# EUROPEAN PATENT SPECIFICATION

(11) **EP 0 246 642 B1**
(45) Date of publication and mention of the grant of the patent: **18.05.1994**
(21) Application number: 87107362.3
(22) Date of filing: 20.05.1987
(51) Int. Cl.: H01L 29/14, H01L 27/06, H01L 29/76, H01L 29/36, H01L 29/06, H01L 29/80, H01L 31/02, H01L 31/10, H01L 33/00

(54) **A semiconductor device using new semiconductor structures**
Eine aus neuen Halbleiterstrukturen bestehende Halbleiterschaltung
Dispositif semi-conducteur utilisant des structures de semi-conducteur nouvelles

(30) Priority: 20.05.1986 JP 116775/86
(43) Date of publication of application: 25.11.1987
(73) Proprietor: NEC CORPORATION, Tokyo (JP)
(72) Inventor: Watanabe, Hisatsune, Minato-ku Tokyo (JP)
(74) Representative: Glawe, Delfs, Moll & Partner

(56) References cited:
- US-A- 4 103 312
- US-A- 4 503 447
- US-A- 4 581 621
- JOURNAL OF VACUUM SCIENCE OF TECHNOLOGY, vol. B4, no. 1, January/February 1986, pages 299-309 ; S. MATSUI et al. : "New selective deposition technology by electron beam induced surface reaction"

## Description

### BACKGROUND OF THE INVENTION

### (Application Field in Industry)

The present invention relates to a semiconductor device using a conceptionally novel semiconductor structures (hereinafter referred to as a "structure").

### (Prior Art)

In conventional semiconductor elements or integrated circuits, diodes, transistors and light-emitting and -receiving elements are realized by variously combining PN junctions, MOS junctions or heterojunctions. Integrated circuits and optoelectronic integrated circuits are put into practical use by precisely processing resistors, capacitors, electrodes and wiring materials.

### (Problems to be Solved by the Invention)

In order to improve the performances of these semiconductor elements, efforts have been made to improve the internal structures, for example, miniaturization thereof, reduction in the film thickness, and achievement of high-dimensional structures or high integration.

However, it is considered from the viewpoint of the present integrated circuits of ultrahigh integration density that the sizes of individual active elements, transistors and diodes will be minimized only to the order of 0.1 micron. The reason for this is based on the basic principle of each individual active element. In the case of transistors, for example, any transistor structure needs a carrier transit region and it is essential to control the number or rate of electrons or holes passing through this region. Therefore, if it is intended to design the carrier transit region so that its size is for example, 0.01 micron, it is impossible to form an electrode for controlling carriers in this region, or even if such an electrode can be formed, the electrode resistance will be extremely high due to its thinness and the controllability will lower eventually.

Also in semiconductor elements which emit or receive light as their basic functions, even if the light-emitting and -receiving regions can be made extremely minute, the reduction in size of the electrode portions is limited from the viewpoint of the electrode function.

Thus, in the conventional semiconductor elements, even if active regions are miniaturized so as to be extremely minute, the reduction in size of control electrodes or wiring materials is limited, so that the volume which is occupied by the electrodes and wiring portions in the entire volume of the integrated circuit increases considerably, and this leads to increase in the stray capacitance and stray resistance, resulting in restriction against the achievement of high performance.

US-A-4 103 312 shows a structure of alternative arrangement of P and N regions and maxtrix arrangement of N regions in a P region. Respective P and N regions are uniform semiconductor regions. Therefore miniaturization of the regions has a limitation.

### SUMMARY OF THE INVENTION

The primary object of the present invention is to fundamentally overcome the above-described problem of wiring in an integrated circuit of ultrahigh integration density or the dimensional limitation on control electrodes.

This object is achieved by a semiconductor device as claimed in claim 1.

In principle, the present invention employs as semiconductor regions superatoms which are based on a novel concept and which will be described below.

A superatom is formed in such a manner that a spherical first semiconductor having a size (e.g., 50 Å (10Å = 1 nm)) substantially equal to the wave function of electrons is positioned in a second semiconductor which surrounds it and a necessary number of impurity atoms are doped into the spherical semiconductor region. However, in the case where the doping impurity is a donor impurity, the electron affinity must be smaller than that of the second semiconductor.

When donor impurity is doped in such a structure, a so-called modulation doped structure is obtained in which donor atoms and electrons supplied therefrom are spatially separated from each other. A structure in which this principle is applied to a planar hetero interface is a modulation doped structure which has already been presented by R. Dingle et al. in Published Japanese Translation of the PCT patent Application No. 55-500196, and an object of this presentation is to improve the electron mobility by the spatial separation between donor atoms and transit electrons.

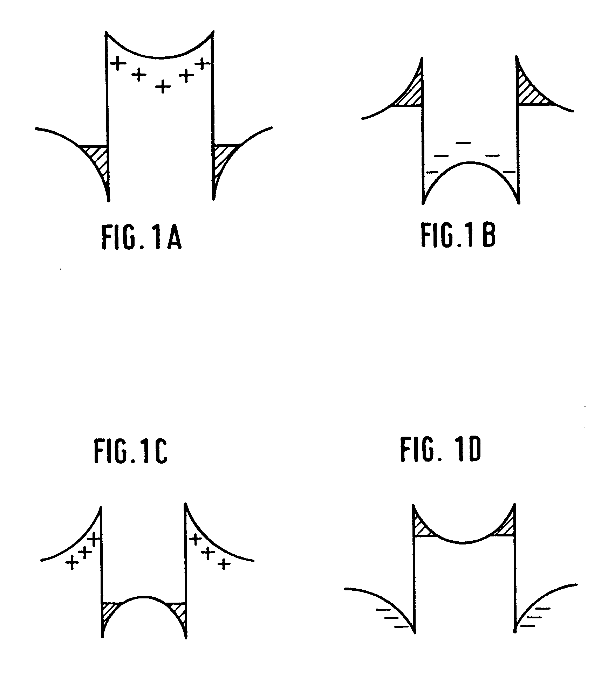

The superatom is based on the same principle as the modulation doped structure in regard to the spatial separation between ionized impurity and carriers, but it does not aim at improving the carrier mobility. In the first spherical semiconductor, N donors are present in a state wherein they are ionized positive, while in the second semiconductor region, N electrons are present. In this case, however, the N electrons are localized outside the first spherical semiconductor in such a manner that the electrons are in close contact with each other within the spherical film. The state in this case is shown in Fig. 1(a). The charge balance state of this superatom will be found to be similar to that of an atom. More specifically, in an ordinary atom, for example, an atom whose atomic number is N, N protons are present in the nucleus and N electrons are localized around the nucleus in a variety of charge distribution patterns. The same is the case with the structure shown in Fig. 1(a) in regard to the point that the numbers of positive and negative charges are equal to each other at all times and the charges balance with each other. However, the structure shown in Fig. 1(a) greatly differs from that of an ordinary atom in that the size of the portion of the illustrated structure which corresponds to the nucleus of the atom, that is, the radius of the first spherical semiconductor region, is substantially equal to the spread of the wave function of electrons, i.e., about 100 Å. Although the charge balance state of the illustrated structure is similar to that of an ordinary atom, the diameter of the former is 10 to 100 times that of the latter, so that this structure is named "superatom". However, when an energy level that traps electrons is present at the interface between the first spherical semiconductor and the second semiconductor which surrounds it, or when an acceptor impurity or a trap is present in the second semiconductor, the number of electrons which are localized in the spherical film is not coincident with the number of donors and the charge balance is therefore destroyed. The structure in such a state will also be referred to as "superatom".

As the diameter of a superatom decreases, the state of electrons which are localized therein becomes close to one wherein they are trapped zero-dimensionally, so that the electron energy is discrete. If, at the same time, one electron spreads over the whole of the spherical film, the electron is considered to be on a quantum level corresponding to the atomic orbital.

This quantum level greatly depends on the properties of semiconductor materials constituting the superatom. Parameters which have effects on the energy level include the band gaps, electron affinities, dielectric constants and effective masses of the first and second semiconductor materials. The energy level also changes by a large margin in accordance with a change in the diameter of the first spherical semiconductor.

If a structure in which donor impurity is doped into the first semiconductor is called a superatom, then a structure in which acceptor impurity is doped into the first semiconductor will appropriately be called a super-antiatom. This is becuase the regions in which positive and negative charges are present, respectively, are completely reverse to those in an ordinary atom and this structure is therefore similar to an antiatom. This structure is shown in Fig. 1(b). In this case, the sum of electron affinity and energy band gap of the first semiconductor must be larger than the second semiconductor. Further, as shown in Fig. 1(c), there may be a case where, even when the electron affinity relationship is opposite to that shown in Fig. 1(a), electrons are present in the spherical semiconductor and localized within the spherical film inside the hetero interface. The number of localized electrons in this case is determined by the number of donors doped outside the spherical semiconductor and the distance from the interface. Since the charge distribution shown in Fig. 1(c) is in inverse relation to that of a superatom, the illustrated structure may be called an "inverse superatom" or a "negative superatom".

Similarly, an inverse super-antiatom which is in inverse relation to a super-antiatom can be produced as shown in Fig. 1(d). Although nobelium, whose atomic number is 102, is the largest element of the known ordinary atoms, it is possible to realize a super-superatom whose atomic number is more than 102 since the number of impurity atoms doped into a superatom can be set as desired, theoretically. However, the difference in properties between individual superatoms is not drastically large as in the case of ordinary atoms. This is because the diameters of superatoms are relatively large and the energy difference between quantum levels is small correspondingly and the difference in overall properties between superatoms is therefore relatively small.

The radiuses of the first spherical semiconductor shown in Figs. 1(a), 1(b), 1(c) and 1(d) should have substantially the spread of the wave function of the material forming the first spherical semiconductor. More specifically, they are designed in a range between 30 Å and 150 Å. When the first spherical semiconductor has a shape other than spherical shape, its thickness should have the same range. The thickness of the second semiconductor surrounding the first spherical semiconductor may have arbitrarily thickness, if it has such thickness that induced carriers based on the impurities in the first spherical semiconductor may be confined. However, if it is too thick, it is not expected when the novel structures contact with each other, that carriers in the contacting novel structures interact to achieve rectifying junction or perform an electrical path. Therefore, the thickness of the second semiconductor should have a thickness in a range between 500 Å and 1,000 Å. Impurities may be induced into the first spherical semiconductor or the second semiconductor up to their solubility limits. Their concentration may be controlled to have more lower value in order to control the resistivity when the novel structures form an electrical path by contacting with each other.

There may be several types of the spherical configuration of superatoms. Although the perfectly spherical configuration is ideal, it is also possible to adopt oval, egg-shaped, cylindrical and dice-shaped configurations. This is because the existing probability of a particular electron is similar in all directions from the center of the superatom concerned. More specifically, in the case of a dice-shaped superatom, as the probability of a particular electron being present in one of the six faces of the dice is equal to those in the other faces, the size of the dice must be small correspondingly. When only the probability of a particular electron being present in a certain face of the dice is close to 1 and those in other faces are relatively small, even if any stimulation is given to the face which involves a relatively small probability, there is substantially no change in the quantum state of electrons, and this is therefore inconvenient to assemble a three-dimensional circuit such as that described later.

When superatoms are arranged in a row and they are disposed so close to each other that the wave functions of electrons localized in the superatoms overlap each other, there is generated a probability of a particular electron being present in a plurality of superatoms under appropriate conditions. This corresponds to a molecular orbital in a diatomic molecule. A structure in which superatoms are arranged one-dimensionally will be called a "one dimensional super-superlattice". In other words, this is a superlattice consisting of superatoms. If superatoms are arranged two-dimensionally and three-dimensionally, a two-dimensional super-superlattice and a three-dimensional super-superlattice are obtained, respectively.

Even when the distance between adjacent superatoms is so large that the wave functions do not overlap each other, electrical interaction or conductor between the superatoms can be induced by application of an external field such as an external electric field, stress or light.

Considering a superatom doped with 14 donors, this atom corresponds to silicon, whose atomic number is 14, and therefore this superatom may be regarded as super silicon. If four super silicon atoms are disposed in a tetrahedral pattern, a diamond-shaped super silicon crystal is obtained. However, the properties of such a crystal are different from those of the conventional silicon crystal.

If super gallium doped with 31 donors and super arsenic doped with 33 donors are similarly arranged in a tetrahedral pattern, super gallium arsenide is formed.

Since superatoms can be disposed relative to each other so as to form any desired crystal structure, it is possible to realize any desired supercrystal with any desired superatoms.

These super-superlattices can be formed using superatoms, inverse superatoms, super-antiatoms or inverse super-antiatoms. A super-superlattice consisted of superatoms or super-antiatoms alone will be referred to as a "unipolar super-superlattice", and a super-superlattice in which superatoms and super-antiatoms are mixedly present will be referred to as a "bipolar super-superlattice". In other words, a super-superlattice in which only electrons or holes are localized will be called a unipolar type super-superlattice even if it consists of a mixture of superatoms and inverse superatoms or a mixture of super-antiatoms and inverse super-antiatoms, while a super-superlattice in which electrons and holes coexit will be called a bipolar super-superlattice.

The quantum level of electrons or holes in a superatom, super-antiatom or super-superlattice is readily changed by application of an external electric field or magnetic field. This is because the presence of an electric field biases the localized state of electrons or holes and the application of a magnetic field leads to transformation of the wave function.

Accordingly, application of a potential to each individual superatom by some means changes the properties of the superatom.

When the potential of an endmost superatom of a one-dimensional super-superlattice is changed, the charge distribution of electrons of each superatom is changed, and this leads to a change in the quantum state of the superatom which is disposed at the opposite end.

In a two-dimensional super-superlattice, electrical stimulation of one superatom leads to a change in the whole of the two-dimensional lattice. The same is the case with a three-dimensional super-superlattice.

Even when there is a difference in number of doping impurity atoms between superatoms constituting a super-superlattice, a stimulation of one superatom affects the whole of the super-superlattice. However, the change (deviation of charges) in a heavily-doped superatom is smaller than that in a lightly-doped superatom.

In the case of a bipolar super-superlattice, it is possible to emit light from superatoms if a superatom and a super-antiatom which are adjacent to each other are appropriately biased, similar to injection luminescence in a light-emitting diode by means of a forward bias. Conversely, if photons of appropriate energy are incident on the bipolar super-superlattice, a voltage is generated between two positions on this superlattice. Combination of these fundamental principles enables a formation of a highly integrated three-dimensional circuit or a three-dimensional optoelectronic integrated circuit.

### BRIEF DESCRIPTION OF THE DRAWINGS

Fig. 1 shows the respective energy band structures of conceptionally novel structures employed in the present invention, in which: Fig. 1(a) shows a superatom; Fig. 1(b) shows a super-antiatom; Fig. 1(c) shows an inverse superatom; and Fig. 1(d) shows an inverse super-antiatom.

Fig. 2 shows a one example of an inverter circuit formed by arranging superatoms and a super-antiatom, in which: Fig. 2(a) shows the spatial arrangement thereof; and Fig. 2(b) shows an equivalent circuit of the inverter circuit.

Fig. 3 is a perspective view of one example of a three-dimensional integrated circuit formed by three-dimensionally arranging superatoms and super-antiatoms at desired positions, respectively.

Fig. 4 is a view showing a unit formed by linearly connecting together superatoms and super-antiatoms.

Fig. 5 is a view showing a state of the unit illustrated in Fig. 4 in which the center of the unit is replaced by a material (dot region) having a smaller band gap.

Fig. 6 shows one example of an optoelectronic integrated circuit formed by three-dimensionally arranging superatoms and super-antiatoms, in which: Fig. 6(a) shows the spatial arrangement thereof; and Fig. 6(b) shows an equivalent circuit of the integrated circuit.

### DETAILED DESCRIPTION OF PREFERRED EMBODIMENTS

Examples in which element circuits which are basic units to constitute an integrated circuit are formed using superatoms will be described hereinunder.

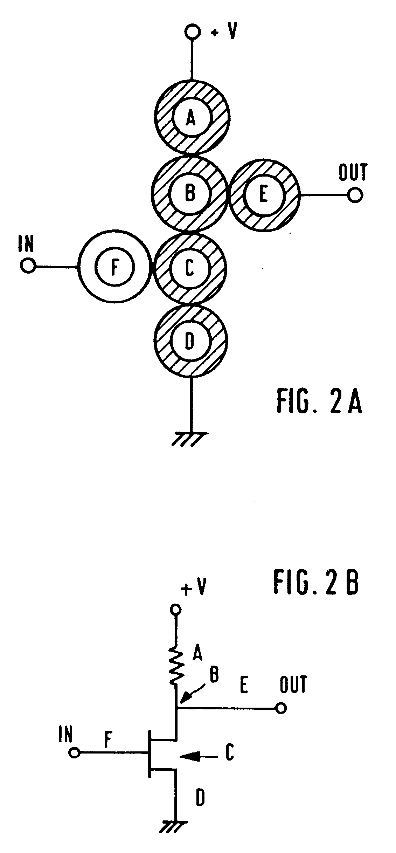

Fig. 2(a) shows an inverter circuit consisting of seven superatoms A, B, C, ..., F, and Fig. 2(b) shows an equivalent circuit thereof. Only F is a super-antiatom and A to E are superatoms. When a positive voltage is applied to a terminal V, a current flows through the superatoms A to E. If, at this time, the super-antiatom F is biased negative, electrons localized in the superatom C are not allowed to be localized in C but pushed toward B and D, so that the resistance of the current path from A to D increases, resulting in the current being cut off. If this change is viewed by way of the potential of the superatom E serving as an output terminal, the potential of the superatom E, which is first close to a ground potential, rises to a power supply voltage V as a result of the cut-off of the current caused by the application of the bias to the superatom F serving as an input terminal. Thus, an inverter circuit is formed. It is preferable, in order to improve the efficiency of the whole circuit, to increase the amount of impurity atoms doped into the superatoms B, D, E and F and to relatively decrease the amount of impurity atoms doped into the superatom A serving as a resistor. The amounts of impurity atoms doped into the superatom C and the super-antiatom F, respectively, which constitute a FET region are related to each other and should be adjusted so that the mutual conductance is maximized.

Although an example in which superatoms are arranged two-dimensionally is shown in Fig. 2(a), an inverter can be formed on the basis of completely the same principle even if the input/output terminals or the power supply terminal is arranged three-dimensionally. In other words, if a superatom G serving as an input gate is disposed so as to extend in the direction perpendicular to the plane of the drawings, there is no change in the operation.

In the arrangement shown in Fig. 2(a), if another similar circuit is disposed in series, a 2-input NAND circuit is obtained. The number of inputs may be increased to form a multi-input circuit. Further, if a plurality of output terminal superatoms are appropriately disposed, a multi-output circuit is obtained.

On the basis of this principle, it is possible to form a three-dimensional AND, OR, NAND or NOR circuit as desired. A flip-flop circuit can also be formed.

Three-dimensional circuits employing superatoms as described above have considerably great advantages.

First, it is possible to form an integrated circuit of ultrahigh integration density in which the sizes of necessary resistors and transistors are 100 Å or less.

Secondly, since there is no wiring portion made from a metallic material or the like and the transfer of potentials to superatoms serving as individual resistors and transistors can be effected not only in three-dimensional six directions, i.e., x, y and z, but also in any other desired directions, it is possible to provide any desired three-dimensional wiring.

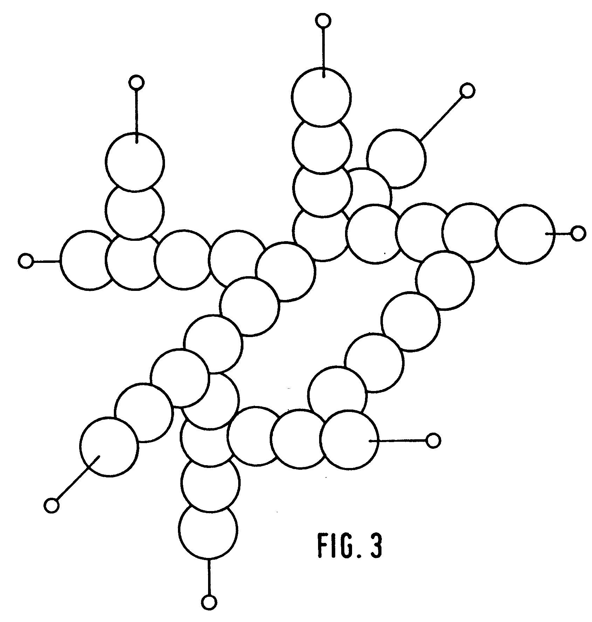

Fig. 3 schematically shows one example of an arrangement that has the above-described advantages. Employment such as arrangement enables a necessary logic circuit or memory circuit to be formed with a ultrahigh integration density.

The following is a description of a superatom element having a light-emitting or -receiving function and a circuit using the same.

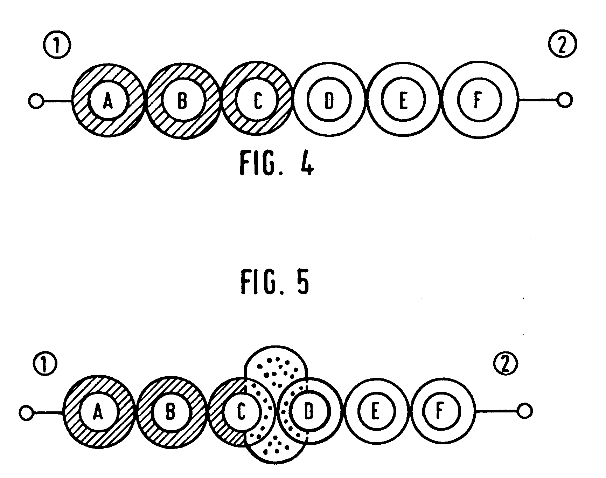

Fig. 4(a) shows an arrangement in which three superatoms A, B and C and three super-antiatoms D, E and F are linearly disposed. When terminals 1 and 2 are biased negative and positive, respectively, injection luminescence occurs at the interface between C and D where a PN junction is present. Conversely, if photons of appropriate energy are incident on this junction portion, a voltage is generated between the terminals 1 and 2. In this case, the wavelength of light which is to be emitted or received can be set as desired by appropriately selecting values for physical properties of semiconductor materials for the superatom C and the super-antiatom D forming the PN junction. A bipolar super-superlattice can be formed by one- to three-dimensionally arranging an array having such a PN junction.

The wavelength of light which is emitted from or received by a PN junction formed by a superatom and a super-antiatom is substantially equal to the band gap of a semiconductor material which is present at the boundary of the superatom and the super-antiatom. Accordingly, it is possible to emit or receive light of desired wavelength (particularly wavelengths on the low-energy side) by selecting a semiconductor material for the dot region shown in Fig. 5 so that the band gap at and near the boundary is appropriate. This embodiment does not form part of the claimed invention It is particularly important for forming a PN junction element to set the wavelength of light at a lower energy side than that of the band gap of the semiconductor material surrounding the superatom or the super-antiatom. This is because a portion which emits or receives light appears to be transparent when seen with the light of low-energy wavelength. In other words, it is possible to access the element with light from the outside or to the outside.

If M PN junction elements such as that shown in Fig. 4 are prepared and made different from each other in terms of the wavelength of light to be emitted or received so that they have wavelengths λ₁, λ₂, ..., λ_{M}, respectively, it is possible to access a particular PN junction element by appropriately selecting the wavelength. In the case of a light-emitting element, it is possible to immediately identify a PN junction element which has operated by checking the wavelength of light emitted therefrom. When light of wavelength λᵢ is externally applied to a particular PN junction element, photovoltages are generated from all the elements which are sensitive to light of wavelengths longer than λᵢ. This means that it is impossible to access one particular element. However, if two different kinds of wavelength are provided for incident light and two different kinds of light are sequentially irradiated, it is possible to classify the elements into groups, that is, a group which responds to both the light rays of two different kinds of wavelength, a group which responds to neither of them, and a group which only responds to the light of shorter wavelength. Accordingly, it is possible to discriminatingly specify one particular PN junction element alone by appropriately setting two different kinds of wavelength for incident light and the spacing between the two wavelengths.

A PN junction element such as that shown in Fig. 4 can be incorporated in a part of a three-dimensional circuit such as that exemplarily shown in Fig. 3. More specifically, it is possible to arrange a logic circuit or a memory circuit such that, as a part of such a circuit operates, light is emitted from that portion. At that time, if the wavelength of emitted light is checked, it is possible to identify a PN junction that has operated.

On the other hand, if light of particular wavelength is externally made incident on the circuit, all the light-receiving PN junctions sensitive to light of this wavelength are activated to induce voltages. If the induced voltages are considered to be input signals, it is possible to effect a simultaneous multiple input to a three-dimensional circuit. To input a signal only to one particular input PN junction, it suffices to set the response wavelength of that portion to a lower energy side. Alternatively, it suffices to add a logic circuit which judges that a particular PN junction has received an input signal only when it responds only once in two input operations in which light rays of two different wavelengths are applied, respectively, as described above.

If input and output operations are effected using light in the way described above, there is no need for input and output wirings in a three-dimensional circuit, which is considerably advantageous to achievement of high integration density. In the described optical input/output system, it is unnecessary to narrow light itself to a microscopically thin beam, and only a specific microscopic PN junction responds to light which is applied to the whole of the three-dimensional circuit. When an output is to be obtained from such a three-dimensional circuit also, it is unnecessary to provide any special device for positionally detecting an output portion, and it is possible to identify an output portion simply by checking the wavelength of emitted light, which means that there is no need for any output wiring.

The basic principle of an ultrahigh density three-dimensional optoelectronic integrated circuit using light as input and output signals has been described above.

The following is a description of examples of materials employed to realize such a semiconductor element by way of a superatom taken as one example.

A superatom consists of two semiconductors as described above, that is, a first spherical semiconductor and a second semiconductor which surrounds it. The condition to realize a superatom is that the electron affinity of the first spherical semiconductor is smaller than that of the second semiconductor. Accordingly, a superatom is formed by employing AlAs as the first semiconductor and GaAs as the second semiconductor and doping donor impurity such as silicon or sulfur into the AlAs ball. If the two semiconductors have the same lattice constant as in the case of AlAs and GaAs, no special stress is generated at the interface, and therefore it suffices to select two semiconductor materials in accordance with the known size of electron afffinity. It is possible to obtain a very large number of possible combinations of semiconductor materials by appropriately selecting compositions of multiple mixed crystal semiconductors consisting of three or more elements, for example, InP/In_{0.53}Ga_{0.47}As and In_{0.48}Ga_{0.52}P/GaAs.

A superatom can be realized even when the respective lattice constants are not coincident with each other. In such a case, there is possibility of misfit dislocations being generated at the interface due to a stress based on the lattice mismatching. However, as is well known, when the thickness is relatively thin (i.e., the diameter of the ball is relatively small in the case of a superatom), no misfit dislocation is generated. Correspondingly, a stress at the interface or in the whole of the inside of the first spherical semiconductor. This stress causes the apparent electron affinity to change, thus generating a level difference between the conduction bands at the hetero interface. For example, if SiGe mixed crystal is employed as the first spherical semiconductor and Si is employed as the second semiconductor, the stress applied to the SiGe mixed crystal causes the bottom of the conduction band thereof to become higher in terms of energy. Accordingly, if donors are doped into the SiGe mixed crystal, a superatom can be formed.

It is not absolutely necessary for realization of a superatom that the first and second semiconductors should be crystals. Even if the first semiconductor is, for example, amorphous, there is no problem, provided that the doped donors can act as donors. It is also possible to employ for example, amorphous SiC as the first semiconductor and Si as the second semiconductor. In this case, however, it is necessary that there should be fewer interfacial energy levels at the interface between SiC and Si. If the number of interfacial energy levels is relatively large, electrons supplied from donors in SiC are all trapped by the interfacial energy levels, so that no electron gas in the shape of a spherical film cannot be formed and no superatom is therefore obtained. If there is no interfacial energy level, the number of donors and the number of electrons in the electron gas are equal to each other and a superatom is thus obtained. However, even if there is more or less interfacial energy levels, a pseudo superatom is obtained, provided that the number of electrons is smaller than that of donors. In other words, it is possible, even in such a case, to obtain a pseudo superatom in which the number of positive charges in the spherical semiconductor is not coincident with the number of electrons in the spherical film. As to donors, impurities are not necessarily limitative and point defects, line defects or plane defects which are defined by vacancies or interstitial atoms may also be employed.

The first spherical semiconductor may be a semiconductor having an extremely large band gap, even a material called an insulator upon occasion, provided that the employed material satisfies the essential requirements to form a superatom. For example, GaN, AlN or SiO₂ may also be employed. It is known that the interface between SiO₂ and Si is formed into an interface having an extremely low interfacial level density by an appropriate heat treatment. Accordingly, if donors are doped into SiO₂, it is possible to form a superatom which has SiO₂ as the first spherical semiconductor. The donors doped in SiO₂ are not necessarily needed to form a shallow energy level in SiO₂ but only required to form an energy level sufficient to be able to supply electrons toward Si which surrounds SiO₂.

Examples of the above-described materials are listed in Table 1 below. There are a variety of combinations of materials which satisfy the requirements to form a superatom or a super-antiatom, in addition to the listed ones.

**Table 1**

| | First spherical semiconductor materials | Second semiconductor material |
|---|---|---|
| Lattice matching materials | AℓAs | GaAs |
| | InP | InGaAs mixed crystal |
| | InAℓAs mixed crystal | InGaAsP mixed crystal |
| | GaSb (superatom | InAs |
| | InAs (super-antiatom) | GaSb |
| Lattice mismatching materials | SiGe mixed crystal (strained) | Si |
| | Si | SiGe mixed crystal (non-strained) |
| | SiC mixed crystal | Si |
| | GaAs | InGaAs mixed crystal |
| | AℓN | GaAs |
| Amorphous materials | Amorphous SiO₂ | Si crystal |
| | Amorphous SiC | Si crystal |
| | Crystalline ZnSe | Amorphous Ge |
| | Amorphous Si | Amorphous Ge |

The following is a description of the method of forming a superatom and a super-superlattice or a three-dimensional circuit employing superatoms.

One superatom is formed in the manner described below. Selective etching and deposition described by Matsui and Mori in Journal of Vacuum Science & Technology, vol. B4, No. 1 (1986), pp. 299 to 304, will first be explained. In this method, a material gas is adsorbed to the surface of a substrate and a part of the adsorption layer is irradiated with a narrowed electron beam. As a result, etching or deposition is caused only in the irradiated portion. Sufficiently narrowing the electron beam enables an extremely narrow region alone to be subjected to etching or deposition. Presently, it is possible to narrow the diameter of an electron beam to 3 to 4 Å, and employment of this beam enables local excitation of one specific adsorption molecule alone in the adsorption layer. As a result, optimization of the adsorbent species, the substrate temperature and the electron beam properties permits etching of one to two atoms in the surface of the substrate or enables deposition of one atom through a chemical change of the adsorbent species. The position where etching or deposition is to take place can be set as desired by scanning the substrate with the electron beam. If a secondary electronic image is formed using the electron beam before adsorption of the material gas, the position to which the electron beam is to be applied can be observed with the naked eye on the basis of the same principle as that of a scanning electron microscope.

Since the adsorption coverage can be set at 1 throughout the surface of the substrate by appropriately selecting the adsorbent gas supply pressure and the substrate temperature, one-atom etching or one-atom deposition can be carried out at any desired primitive position on the substrate.

Formation of one superatom can be achieved by controlling the scanning region with the electron beam so that the first semiconductor is spherically buried eventually. In the course of the scanning, a doping gas is adsorbed to the whole surface of the substrate, and a necessary number of atoms are excited by an electron beam to effect deposition, thus enabling a necessary number of donors to be doped into the spherical portion of the superatom.

A unipolar super-superlattice, a bipolar super-superlattice or a three-dimensional circuit employing superatoms such as that shown in Fig. 3 is formed by a method which is theoretically the same as the above-described method for producing a superatom. First, a desired three-dimensional circuit which is to be assembled is cut along a plane which is parallel to the surface of the substrate and the atomic arrangement within said plane is stored in the memory of a computer. The atomic arrangements in all the atomic planes, from the lowermost layer of the three-dimensional circuit to the uppermost layer thereof, are computed by the computer and then stored in the memory.

One-molecule layers are adsorbed to the surface of the substrate, one by one, and a necessary portion is excited with an electron beam according to the information stored in the memory of the computer to cause a deposition reaction. Remaining adsorbed molecules are removed by means, for example, of a thermal treatment or optical excitation of the whole surface.

This procedure is carried out for all the necessary atomic planes so as to form layers of film up to the final atomic plane while effecting patterning under the control of the computer, whereby a desired three-dimensional circuit is formed.

A dice-shaped or cylindrical superatom can be formed more easily. First, a double hetero structure is formed in an ordinary thin film forming apparatus. Then a rectangular or circular pattern is drawn by electron beam lithography or ion beam lithography, and with this portion left, the peripheral region is etched using, for example, a dry etching technique. Then, the etched region is filled back by a selective chemical vapor deposition (CVD) technique. As a material to be filled between superatoms, the same material as that used to sandwich the intermediate layer in the double hetero structure is employed. Alternatively, a material is employed which has an electron affinity that enables an electron gas to be also formed at the side surfaces eventually.

A three-dimensional circuit in which superatoms and super-antiatoms are mixedly disposed is realized by repeating the procedure of forming a single hetero structure, forming a pattern, etching, doping, and material-filling between superatoms. More specifically, a film of a second semiconductor which has a larger electron affinity and a smaller band gap than those of a first semiconductor is first formed, and the first semiconductor is subsequently deposited. The first and second semiconductors have respective thicknesses which are most suitable for forming a three-dimensional circuit (probably about 100 Å). Next, a rectangular or circular pattern having a size of about 100 Å is formed by lighography and etching is then carried out to leave the first semiconductor layer in a rectangular or circular pattern Next, a doping material is adsorbed to the whole surface of the first semiconductor layer and then bombarded with a focused electron beam or a focused ion beam at a necessary rectangular or circular pattern to effect deposition of a necessary number of donors or acceptors. The control of the number of deposited donors or acceptors is effected according to a previously obtained calibration curve representing the relationship between the dose of an electron beam or an ion beam and the amount of deposition of impurity at accelerated energy. Next, a protection film is deposited, and the impurity is diffused into the first semiconductor layer by thermal diffusion. The etched region is filled back by selective deposition using the protection film as a mask, and the protection film is then removed by etching. At this stage, the whole surface is made flat again. Subsequently, this series of processes is repeated to form a second layer superatom or super-antiatom at a necessary position. This procedure is repeated a necessary number of times to complete a three-dimensional integrated circuit having rectangular or cylindrical superatoms or super-antiatoms as circuit elements.

### [Example 1]

One example of an inverter circuit employing superatoms and a super-antiatom will be described below. Referring to Fig. 2, the first spherical semiconductors A, B, C, D, E and F are on the same plane and each of them is AlAs having a diameter of 70 Å. A second semiconductor surrounding each of the first spherical semiconductors is GaAs. The spherical semiconductors A, B, C, D and E have Si, serving as donors impurity, doped therein so as to become superatoms. The numbers of donors are 7 (super nitrogen atom) for A, 30 (super zinc atom) for B, D and E, and 15 (super phosphorus atom) for C, respectively. The spherical semiconductor F is a super-antiatom which has acceptors doped therein, the number of acceptors being 20 (super anti-calcium atom). The center distances between A, B, C, D, E and F are equal to each other and set at 110 Å. In this structure, A, D, E and F are employed as electrodes, and with a power supply voltage applied between A and D, the potential at F is lowered to be negative. In consequence, the potential at E rises to become positive, and an inverter operation is thus performed. The power supply voltage or the input voltage to F is selected to be an appropriate value in accordance with the diameters of the superatoms and the super-antiatom, the distance therebetween and the number of doping impurity atoms.

In order to avoid troubles such as liberation of electrons from the superatoms due to a strong electric field and an unnecessary shift of a potential to another superatom array, it is desired that an electric field applied to one superatom should be 10⁵ V/cm or less. Accordingly, if the length between A and D is assumed to be 400 to 500 Å, the voltage applied between A and D is set so as not to exceed 0.5 V. The higher the voltage, the higher the resistance to noise. However, as the voltage increases, the amount of heat generated in the whole circuit also increases, which makes it difficult to realize an ultrahigh density three-dimensional circuit. Accordingly, the signal voltage amplitude should be lowered as much as possible. If possible, the voltage should be set at 1 mV or less.

Because of such restrictions, the relationship in size between the number of acceptors to be doped into the super-antiatom F and the number of donors to be doped into the superatom C is critical and therefore set so that the mutual conductance is maximized.

### [Example 2]

The following is a description of a PN junction element such as that shown in Fig. 4 in which three superatoms and three super-antiatoms are connected in series. Referring to Fig. 4, spherical semiconductors A, B, C, D, E and F are all InP, and a region surrounding each of them is In_{0.53}Ga_{0.47}As. The diameter of each spherical portion is set at 100 Å, the center distance between each pair of adjacent superatoms or super-antiatoms is set at 150 Å. All the superatoms A, B and C have donors doped therein, the number of donors doped into each of them being 50. The super-antiatoms D, E and F have acceptors doped therein, the number of acceptors doped into each of them being 60. The numbers of donors in A, B and C the numbers of acceptors in D, E and F are not necessarily equal to each other. The voltage applied between the terminals ① and ② needs, when this element serves as a light-emitting element, to be substantially equal to the band gap of a semiconductor material surrounding each superatom, i.e., In_{0.53}Ga_{0.47}As in this case. Accordingly, it is necessary to apply a forward bias of about 0.7 V.

When a forward bias of about 0.8 V in the form of a pulse is applied to this element, that is, the terminals ① and ② are biased negative and positive, respectively, for about 1 msec, photons having a wavelength of about 1.7 microns are emitted.

### [Example 3] This embodiment does not form part of the claimed invention

As shown in Fig. 5, completely the same experiment as in Example 2 is repeated. In this example, however, the In_{0.53}Ga_{0.47}As crystal in the dot region which is present between the superatom C and the super-antiatom D is replaced by In_{0.60}Ga_{0.40}As having a smaller band gap. In this way, the light-emitting region is confined, so that the luminous efficiency is increased and, in addition, it becomes easy to take out the light emitted therefrom. When a pulse voltage similar to that in Example 2 is applied to the element, light emitted outside become longer wavelength (about 1.9 microns) and become its intensity ten or more times higher.

### [Example 4] This embodiment does not form part of the claimed invention.

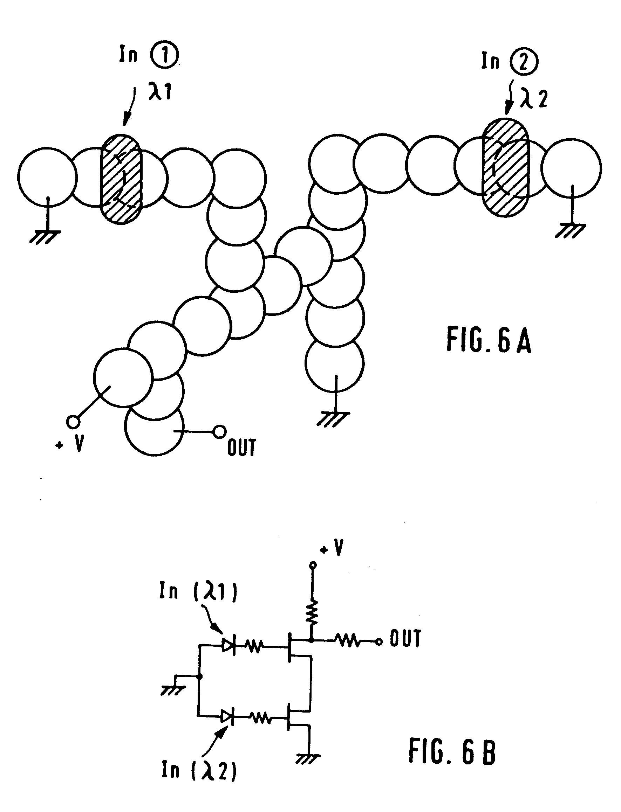

A three-dimensional circuit such as that shown in Fig. 6(a) in which a FET circuit and a light-receiving element are provided is formed. In the drawing, the hatched regions are formed from a material having a smaller band gap in the same way as in Example 3. However, the response wavelengths are different from each other as indicated by λ₁ and λ₂ (λ₁ < λ₂). An equivalent circuit thereof is shown in Fig. 6(b). In such an arrangement, the characteristics of the superatoms can be set so that, when no incident light is applied, the potential at the output OUT is substantially 2/3 of the power supply potential +V, whereas, when incident pulse light of wavelength λ₂ is applied to the three-dimensional circuit, the potential at the output OUT changes to about +1/3 V, and when incident pulse light of wavelength λ₁ is applied, the potential becomes substantially equal to the ground potential.

### [Example 5]

An inverter equivalent to that in Example 1 can be formed by replacing AlAs and GaAs in Example 1 with amorphous SiO₂ and Si, respectively, and doping a heavy metal element such as tungsten into this SiO₂. Although the tungsten doped in SiO₂ does not form a shallow energy level, if it is in the vicinity of the interface between SiO₂ and Si (about several Å), electrons from the tungsten are supplied toward Si.

### [Example 6] This embodiment does not form part of the claimed invention

It is possible to form a three-dimensional circuit in which each of the input PN junction portions In ① and In ② in the arrangement shown in Fig. 6 is defined by a PN junction formed by an inverse-superatom and an inverse super-antiatom and the remaining portions are composed of superatoms and super-antiatoms. As to materials employed in this case, it is preferable to select, for example, InP for the respective spherical semiconductor portions of the superatoms and the super-antiatoms, InGaAsP mixed crystal for the second semiconductor surrounding each of the spherical semiconductor portions, and InGaAS mixed crystal for the respective spherical semiconductor portions of the inverse superatoms and the inverse super-antiatoms. In this case, it is possible to expect advantageous effects similar to those obtained in the arrangement shown in Fig. 5 without the need as in Fig. 5 for any special replacement of materials for the PN junction portions.

### EFFECTS OF THE INVENTION

As has been described above, it is possible, according to the present invention, to miniaturize a semiconductor element so that its size is much smaller than those of the conventional ones. Accordingly, an integrated circuit of ultrahigh integration density can be obtained.

## Claims

1. A semiconductor device including a rectifying junction formed by two semiconductor materials, **characterized** in that said rectifying junction is formed by first and second semiconductor structures arranged in contact with each other, said first semiconductor structure having a first portion of a first material having a first electron affinity and a first band gap and doped with donor impurities and a second portion of a second material having a second electron affinity larger than said first electron affinity and a second band gap smaller than said first band gap, ionized impurities of said donor impurities being confined in said first portion to induce electrons in said second portion in the vicinity of said first portion, said first portion having a thickness substantially equal to the spread of the wave function of said first material and being surrounded with said second portion, and said second semiconductor structure having a third portion of said first material and a fourth portion of said second material, said third portion being doped with acceptor impurities and having a thickness substantially equal to the spread of the wave function of said first material and being surrounded with said fourth portion, ionized impurities of said acceptor impurities being confined in said third portion to induce holes in said fourth portion in the vicinity of said third portion, said second and fourth portions being located in contact with each other.

## Patentansprüche

1. Halbleitervorrichtung mit einem Gleichrichtungsübergang aus zwei Halbleitermaterialien, dadurch **gekennzeichnet,** daß der Gleichrichterübergang durch eine erste und eine zweite Halbleiterstruktur gebildet wird, die in Kontakt miteinander stehen, wobei die erste Halbleiterstruktur einen ersten Bereich aus einem ersten Material mit einer ersten Elektronenaffinität und einer ersten Bandlücke aufweist und mit Donator-Störstoffen dotiert ist und einen zweiten Bereich aus einem zweiten Material mit einer zweiten Elektronenaffinität, die größer ist als die erste Elektronenaffinität, und einer zweiten Bandlücke, die kleiner ist als die erste Bandlücke, aufweist, wobei ionisierte Störstoffe der Donator-Störstoffe in dem ersten Bereich gehalten sind, um Elektronen in dem zweiten Bereich in der Nähe des ersten Bereichs zu induzieren, wobei der erste Bereich eine Dicke im wesentlichen gleich der Ausdehnung der Wellenfunktion des ersten Materials aufweist und vom zweiten Bereich umgeben ist, und wobei die zweite Halbleiterstruktur einen dritten Bereich aus dem ersten Material und einen vierten Bereich aus dem zweiten Material aufweist, wobei der dritte Bereich mit Akzeptorstörstoffen dotiert ist und eine Dicke im wesentlichen gleich der Ausdehnung der Wellenfunktion des ersten Materials aufweist und von dem dritten Bereich umgeben ist, wobei ionisierte Störstoffe der Akzeptorstörstoffe im dritten Bereich gehalten sind, um Löcher im vierten Bereich in der Nähe des dritten Bereiches zu induzieren, wobei der zweite und der vierte Bereich in Kontakt miteinander angeordnet sind.

## Revendications

1. Dispositif à semiconducteurs comportant une jonction de redressement formée par deux matériaux semiconducteurs, caractérisé en ce que ladite jonction de redressement est formée par des première et seconde structures semiconductrices disposées en contact l'une avec l'autre, ladite première structure semiconductrice comportant une première partie d'un premier matériau ayant une première affinité électronique et une première largeur de bande interdite et dopée avec des impuretés donneuses et une seconde partie d'un second matériau présentant une seconde affinité électronique plus grande que celle de ladite première affinité électronique et une seconde largeur de bande interdite inférieure à ladite première largeur de bande interdite, les impuretés ionisées desdites impuretés donneuses étant confinées dans ladite première partie afin d'induire des électrons dans ladite seconde partie au voisinage de ladite première partie, ladite première partie présentant une épaisseur pratiquement égale à l'étalement de la fonction d'onde dudit premier matériau et étant entourée par ladite seconde partie et ladite seconde structure semiconductrice comportant une troisième partie dudit premier matériau et une quatrième partie dudit second matériau, ladite troisième partie étant dopée avec des impuretés acceptrices et présentant une épaisseur pratiquement égale à l'étalement de la fonction d'onde dudit premier matériau et étant entourée par ladite quatrième partie, des impuretés ionisées desdites impuretés acceptrices étant confinées dans ladite troisième partie afin d'induire des trous dans ladite quatrième partie au voisinage de ladite troisième partie, lesdites seconde et quatrième parties étant placées en contact l'une avec l'autre.
